# FASCICULE DE BREVET EUROPEEN

(11) **EP 3 240 159 B1**
(45) Date de publication et mention de la délivrance du brevet: **21.05.2025**
(21) Numéro de dépôt: 17168111.7
(22) Date de dépôt: 26.04.2017
(51) Int. Cl.: H02K 11/33, H02K 5/22, H02K 7/14, H02K 9/22, H02K 11/00, H05K 7/14

(54) **BARRE DE CONNEXION ELECTRIQUE DESTINEE A ECHANGER DE L'ENERGIE ELECTRIQUE ENTRE UN EQUIPEMENT ELECTRIQUE ET UN RESEAU ELECTRIQUE**
ELEKTRISCHE ANSCHLUSSSCHIENE ZUM AUSTAUSCH VON ELEKTRISCHER ENERGIE ZWISCHEN EINEM ELEKTRISCHEN GERÄT UND EINEM STROMNETZ
ELECTRICAL CONNECTION BAR FOR EXCHANGING ELECTRIC ENERGY BETWEEN AN ELECTRICAL APPARATUS AND AN ELECTRICITY NETWORK

(30) Priorité: 28.04.2016 FR 1653782
(43) Date de publication de la demande: 01.11.2017
(73) Titulaire: Valeo Electrification, 95800 Cergy (FR)
(72) Inventeur: DUCHON, Rudy, 95800 CERGY SAINT CHRISTOPHE (FR)
(74) Mandataire: Valeo Powertrain Systems

(56) Documents cités:
- EP-A1- 2 206 922
- WO-A1-2016/009133
- WO-A1-2016/012666
- US-A1- 2011 163 705

## Description

L'invention a pour objet une barre de connexion électrique destinée à échanger de l'énergie électrique entre un équipement électrique et un réseau électrique.

L'invention concerne également un dispositif électrique comprenant une barre de connexion électrique selon l'invention, un convertisseur de tension comprenant un dispositif électrique selon l'invention, un équipement électrique comprenant un convertisseur de tension selon l'invention, et un compresseur de suralimentation électrique comprenant un équipement électrique selon l'invention.

En général, un moteur électrique, notamment pour véhicule automobile, est alimenté en puissance par des modules électroniques de puissance. En particulier, un module électronique de puissance est alimenté en énergie électrique par une barre de connexion électrique.

Une barre de connexion électrique comprend des traces de puissance destinées à être connectées électriquement à une source d'énergie électrique, de sorte à alimenter en énergie électrique les modules électroniques de puissance. La barre de connexion électrique comprend également des composants de filtrage, par exemple une inductance et des condensateurs, de sorte à filtrer l'énergie électrique destinée à alimenter les modules électroniques de puissance.

Selon l'art antérieur, il existe des barres de connexion électrique comprenant une inductance disposée dans un boitier. Cependant, le boitier de l'inductance est en général volumineux, ce qui a pour inconvénient d'augmenter la taille de la barre de connexion électrique.

Selon l'art antérieur, il existe également des barres de connexion électrique comprenant une inductance montée à nue sur la barre de connexion électrique, c'est-à-dire disposée sans boitier sur la barre de connexion électrique.

L'inductance est en général soudée aux traces de puissance de la barre de connexion électrique. L'inductance étant montée à nue sur la barre de connexion électrique, elle n'est pas protégée lors de l'opération de soudure, et peut être atteinte par de la soudure, en dehors de la zone de connexion avec ladite barre de connexion électrique.

En outre, une telle inductance est en général collée à la barre de connexion électrique de sorte à être fixée mécaniquement, ce qui augmente les coûts et les temps de production d'une telle barre de connexion électrique.

Des barres de connexion électrique similaires sont notamment décrites dans les documents WO2016/012666 A1, US2011/163705 A1 et EP2206922 A1.

De plus, de telles barres de connexion électrique présentent des problèmes de tenue mécanique de l'inductance. En particulier, un jeu résulte du montage de l'inductance sur la barre de connexion électrique, ce qui fragilise le dispositif.

La présente invention vise à remédier aux inconvénients de l'art antérieur en proposant une barre de connexion électrique permettant une bonne tenue mécanique de l'inductance, sans augmenter la taille du dispositif.

A cet effet, la présente invention a pour objet une barre de connexion électrique telle que définie dans la revendication 1, un dispositif électrique tel que défini dans la revendication 5, un convertisseur de tension tel que défini dans la revendication 9, un équipement électrique tel que défini dans la revendication 10 et un compresseur de suralimentation tel que défini dans la revendication 11.

Une trace de puissance est par exemple une pièce conductrice électriquement, notamment métallique, par exemple en cuivre, ladite pièce pouvant être une lame métallique, ou un barreau métallique.

Avantageusement, la disposition des zones de connexion et de réception de la barre de connexion électrique selon l'invention protège le composant électrique lors de la connexion électrique de ce dernier aux première et deuxième traces de puissance.

En outre, la barre de connexion électrique selon l'invention permet de réduire la taille de la barre de connexion électrique, notamment grâce à la suppression du boitier du composant électrique, tout en garantissant une bonne tenue mécanique dudit composant électrique sur la barre de connexion électrique.

La barre de connexion électrique selon l'invention peut également comprendre une ou plusieurs des caractéristiques suivantes, considérées individuellement ou selon toutes les combinaisons possibles :
- la zone de réception est conformée pour recevoir un composant de filtrage, notamment une inductance ; et/ou
- la zone de réception est conformée pour recevoir en force le composant électrique ; et/ou
- la zone de réception est formée dans le surmoulage de la au moins une trace de puissance ; et/ou
- la zone de réception comprend au moins une paroi formant le fond de ladite zone de réception et une paroi s'étendant depuis ledit fond dans une direction sensiblement transversale, notamment dans une direction sensiblement perpendiculaire, par rapport audit fond ; et/ou
- la au moins une paroi a une hauteur supérieure ou égale à la moitié de la hauteur du composant électrique et inférieure à 75% de la hauteur du composant électrique ; et/ou
- la au moins une paroi s'étend de façon continue autour de la zone de réception ; et/ou
- la zone de réception comprend une ouverture configurée pour permettre la réception du composant électrique dans ladite zone de réception ; et/ou
- la barre de connexion électrique comprend des éléments de guidage d'une borne de connexion du composant électrique destinée à être connectée électriquement à la au moins une trace de puissance ; et/ou
- le matériau isolant électriquement est un matériau plastique ; et/ou
- la ou les traces de puissance sont des lames métalliques ; et/ou
- la ou les traces de puissance sont des barreaux métalliques.

L'invention se rapporte également à un dispositif électrique comprenant :
- une barre de connexion électrique selon l'invention, et
- un composant électrique,

dans lequel le composant électrique est reçu dans la zone de réception de la barre de connexion électrique, et
dans lequel une borne du composant électrique est connectée électriquement à la au moins une trace de puissance dans la zone de connexion de la barre de connexion électrique.

Avantageusement, le dispositif électrique selon l'invention permet une réduction des coûts et des temps de production, notamment grâce à la suppression du boitier et grâce à la suppression de l'étape de collage du composant électrique sur la barre de connexion électrique.

En outre, la disposition des zones de connexion et de réception permet une protection du composant électrique lors de la connexion électrique de ce dernier à la barre de connexion électrique.

Le dispositif électrique selon l'invention peut également comprendre une ou plusieurs des caractéristiques suivantes, considérées individuellement ou selon toutes les combinaisons possibles :
- la borne du composant électrique est soudée dans la zone de connexion de la barre de connexion électrique ; et/ou
- le composant électrique est monté en force dans la zone de réception de la barre de connexion électrique ; et/ou
- le surmoulage comprend un orifice traversant recevant la borne du composant électrique ; et/ou
- le composant électrique est un composant de filtrage, notamment une inductance.

L'invention concerne également un convertisseur de tension destiné à contrôler une énergie électrique échangée entre une machine électrique et une source d'alimentation électrique, comprenant :
- un dispositif électrique selon l'invention, et
- un dissipateur thermique configuré pour refroidir le convertisseur de tension,
dans lequel une paroi du dissipateur thermique est disposée en vis-à-vis du dispositif électrique, de sorte que au moins une partie du composant électrique est reçue dans une cavité de ladite paroi du dissipateur thermique.

Avantageusement, un convertisseur de tension selon l'invention permet un refroidissement efficace de l'inductance de la barre de connexion électrique, et ainsi permet une évacuation efficace de la chaleur générée par le dispositif électrique.

Selon un mode de réalisation du convertisseur de tension selon l'invention, un matériau conducteur thermiquement peut remplir l'espace entre le composant électrique et ladite cavité.

L'invention a également pour objet un équipement électrique comprenant une machine électrique et un convertisseur de tension selon l'invention, dans lequel le convertisseur de tension est monté sur la machine électrique.

L'invention concerne également un compresseur de suralimentation électrique, notamment pour véhicule automobile, comprenant un équipement électrique selon l'invention.

D'autres caractéristiques et avantages de la présente invention apparaitront à la lecture de la description et des figures suivantes :
- les figures 1 et 2 sont deux vues d'une barre de connexion électrique selon un mode de réalisation de l'invention,
- la figure 3 représente les traces de puissance sans surmoulage de la barre de connexion électrique de la figure 1,
- les figures 4 et 5 sont deux vues d'un dispositif électrique selon un mode de réalisation de l'invention,
- les figures 6 et 7 représentent deux modes de réalisation d'un dispositif électrique selon l'invention,
- la figure 8 représente une vue en coupe d'une architecture électrique selon un mode de réalisation de l'invention, et
- les figures 9 et 10 représentent des vues respectivement partiellement en coupe et en coupe d'un compresseur de suralimentation électrique selon l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

L'invention a pour objet une barre de connexion électrique destinée à échanger de l'énergie entre un équipement électrique, embarqué dans un véhicule automobile, et un réseau électrique. Le réseau électrique est un réseau électrique du véhicule automobile, notamment un réseau électrique alimenté par une tension électrique de +48V. De préférence, le réseau électrique est un réseau d'énergie électrique continue.

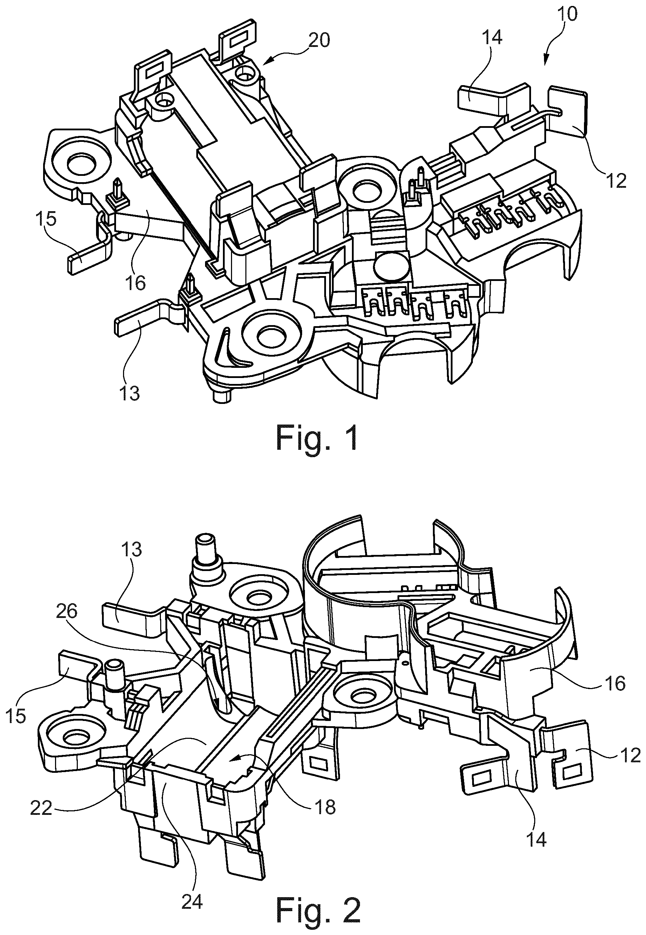

Une telle barre de connexion électrique 10 est représentée sur les figures 1 et 2. La barre de connexion électrique 10 comprend au moins une trace de puissance.

Une trace de puissance est une trace conductrice électriquement, notamment métallique, par exemple en cuivre. Une trace de puissance peut être une lame métallique, ou un barreau métallique.

Une trace de puissance est destinée à transmettre un courant entre le réseau électrique et l'équipement électrique.

Par exemple, sur les figures 1 et 2, la barre de connexion électrique 10 comprend une trace de puissance 12 positive et une trace de puissance 14 négative.

Cependant, les polarités peuvent être inversées, par exemple la trace de puissance référencée 12 peut être négative et la trace de puissance référencée 14 peut être positive.

La trace de puissance 12 positive est notamment destinée à être connectée électriquement à un pôle de polarité positive du réseau électrique, par exemple à une tension électrique de +48V. La trace de puissance 14 négative est notamment destinée à être connectée électriquement à un pôle de polarité négative du réseau électrique, par exemple à une tension électrique de 0V.

Les traces de puissance 12, 14 sont également destinées à être connectées électriquement à au moins un composant électrique, par exemple à un composant de filtrage.

Le composant de filtrage peut être, par exemple, une inductance ou un condensateur. Par inductance, on entend tout composant électronique destiné par sa construction à avoir une certaine valeur d'inductance. Par exemple, une inductance peut désigner une bobine, ou un solénoïde.

La barre de connexion électrique 10 peut également comprendre deux traces de puissance 13, 15, destinées à être connectées électriquement aux traces de puissance 12, 14. Plus précisément, les traces de puissance 13, 15 sont destinées à être connectées électriquement au composant de filtrage, le composant de filtrage étant destinée à être connectée électriquement aux traces de puissance 12, 14.

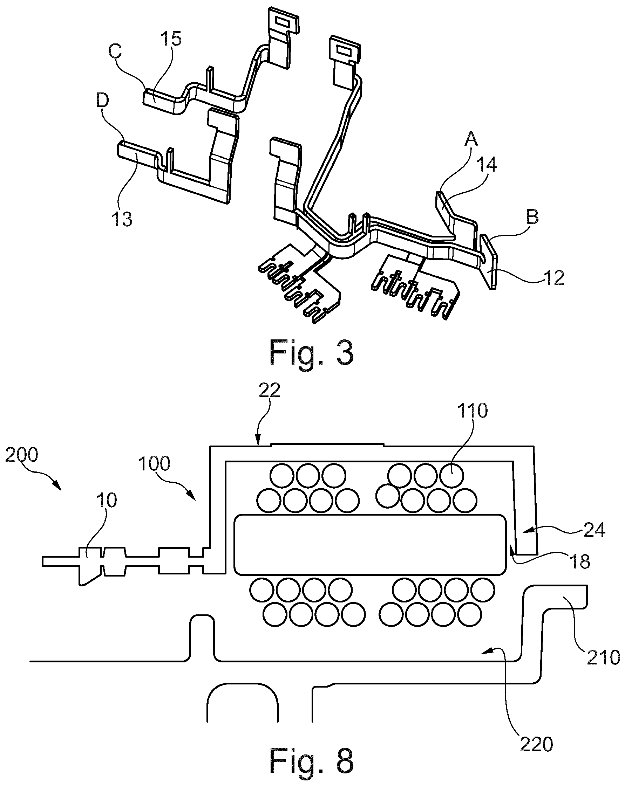

Les traces de puissance 12, 13, 14, 15 comprennent respectivement des bornes B, D, A, C, représentées sur la figure 3, destinées à être connectées à des éléments électriques extérieurs à la barre de connexion électrique 10.

Les traces de puissance 12, 14 sont distinctes l'une de l'autre et sont en partie surmoulées de matériau isolant électriquement, par exemple de matériau plastique.

Par exemple, le surmoulage 16 des traces de puissance 12, 14 est visible sur les figures 1 et 2, et les traces de puissance 12, 14 représentées sans surmoulage sont visibles sur la figure 3.

La barre de connexion électrique 10 comprend une zone de réception 18, notamment visible sur la figure 2, conformée pour recevoir un composant électrique.

Le surmoulage 16 des traces de puissance 12, 14 comprend la zone de réception 18.

Le composant électrique peut être monté en force dans la zone de réception 18. Autrement dit, la zone de réception 18 peut être conformée pour recevoir le composant électrique sans jeu.

Avantageusement, la réception du composant de filtrage en force dans la zone de réception permet d'assurer une bonne tenue mécanique du composant électrique dans la zone de réception.

La barre de connexion électrique 10 comprend également une zone de connexion 20, notamment visible sur la figure 1. Dans la zone de connexion 20, les traces de puissance sont destinées à être connectées électriquement au composant électrique.

La zone de connexion 20 peut être formée dans le surmoulage 16 des traces de puissance.

La zone de réception 18 et la zone de connexion 20 sont séparées par le surmoulage 16. Le surmoulage 16 des traces de puissance 12, 14 comprend une face supérieure, représentée en figure 1, comprenant la zone de connexion 20, et une face inférieure, représentée en figure 2, comprenant la zone de réception 18.

Le composant électrique peut être monté à nu, c'est-à-dire sans boitier, afin de diminuer l'encombrement dudit composant électrique, et par conséquent afin de réduire les dimensions de la zone de réception, et donc les dimensions de la barre de connexion électrique.

Avantageusement, la zone de connexion séparée de la zone de réception par le surmoulage permet une protection du composant électrique lors de la connexion électrique de ce dernier aux traces de puissance.

En effet, le surmoulage permet d'empêcher les projections métalliques générées lors de la connexion électrique du composant électrique aux traces de puissance, notamment par soudure électrique.

Comme représenté sur la figure 2, la zone de réception 18 peut comprendre une paroi 22 formant le fond de ladite zone de réception 18, et une paroi 24 s'étendant depuis ledit fond dans une direction sensiblement transversale, notamment dans une direction sensiblement perpendiculaire, par rapport audit fond.

La paroi 24, dite paroi latérale, peut s'étendre de façon continue autour de la zone de réception 18.

La paroi 24 peut avoir une hauteur comprise entre 50% et 75% de la hauteur du composant électrique.

Une telle paroi permet avantageusement de protéger et de maintenir mécaniquement le composant électrique.

L'invention se rapporte également à un dispositif électrique comprenant une barre de connexion telle que décrite précédemment.

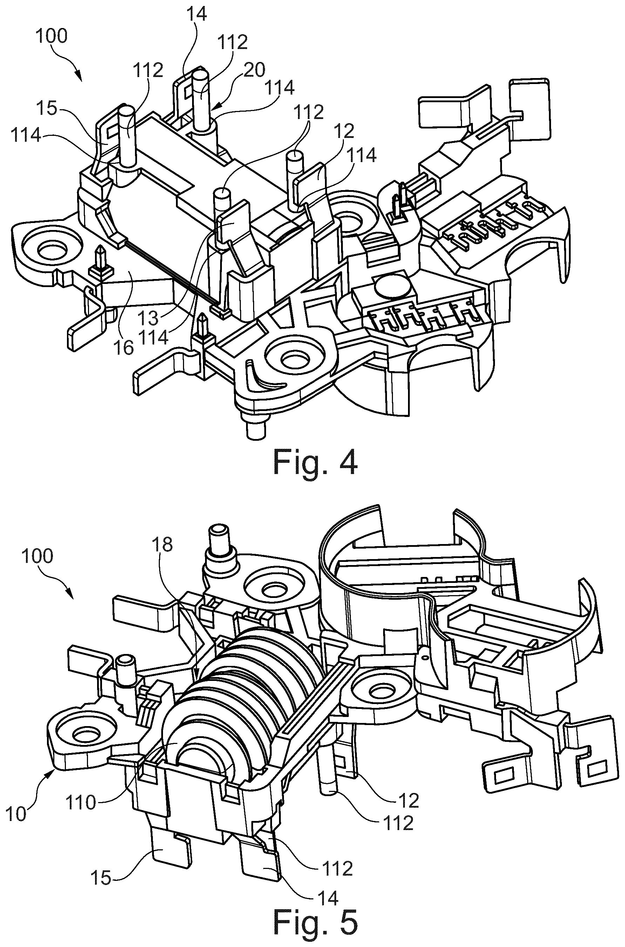

Les figures 4 et 5 représentent un dispositif électrique 100 selon l'invention comprenant une barre de connexion électrique 10 selon l'invention et un composant électrique 110. Dans la suite de la description, le composant électrique sera illustré sur les figures par une inductance.

L'inductance est reçue dans la zone de réception 18 de la barre de connexion électrique 10.

Les bornes 112 de l'inductance sont connectées électriquement aux traces de puissance dans la zone de connexion 20 de la barre de connexion électrique 10.

En particulier, les bornes 112 du composant électrique peuvent être soudées dans la zone de connexion 20 de la barre de connexion électrique 10.

De préférence, comme représenté sur la figure 5, le composant électrique 110 reçu dans la zone de réception 18 est dépourvu de boitier.

Le surmoulage, et plus précisément le fond de la zone de réception 18, comprend des orifices traversants 114 dans lesquels sont reçues les bornes de connexion 112 de l'inductance.

Les orifices traversants permettent la connexion électrique des bornes de connexion du composant électrique aux traces de puissance.

La réception des bornes de connexion du composant électrique dans les orifices traversants, et notamment la réception à force desdites bornes de connexion, permet de garantir une bonne tenue mécanique du composant électrique dans la zone de réception.

En outre, le maintien mécanique du composant électrique dans la zone de réception est dépourvu d'élément de fixation, telle que de la colle.

Avantageusement, un tel maintien mécanique du composant électrique permet une réduction des coûts de production du dispositif électrique.

La barre de connexion électrique 10, et plus précisément le surmoulage 16, peut comprendre des éléments de guidage 26 des bornes de connexion du composant électrique destinées à être connectées électriquement aux traces de puissance.

Les éléments de guidage 26, de préférence agencés au niveau des orifices traversants recevant les bornes de connexion, permettent de guider les bornes de connexion du composant électrique vers la zone de connexion 20.

Les éléments de guidage 26 permettent de recentrer les bornes de connexion du composant électrique en vue de leur connexion électrique aux traces de puissance, et ainsi de connecter correctement le composant électrique aux traces de puissance, sans endommager le composant électrique.

De préférence, afin de permettre un meilleur recentrage des bornes de connexion du composant électrique, la section des orifices de guidage au niveau de la zone de réception du composant électrique est plus grande que la section des orifices de guidage au niveau de la zone de connexion.

Les traces de puissance 12, 14 peuvent également comprendre, dans une zone dépourvue de surmoulage, des bornes de connexion configurées pour permettre une connexion électrique avec des éléments électriques.

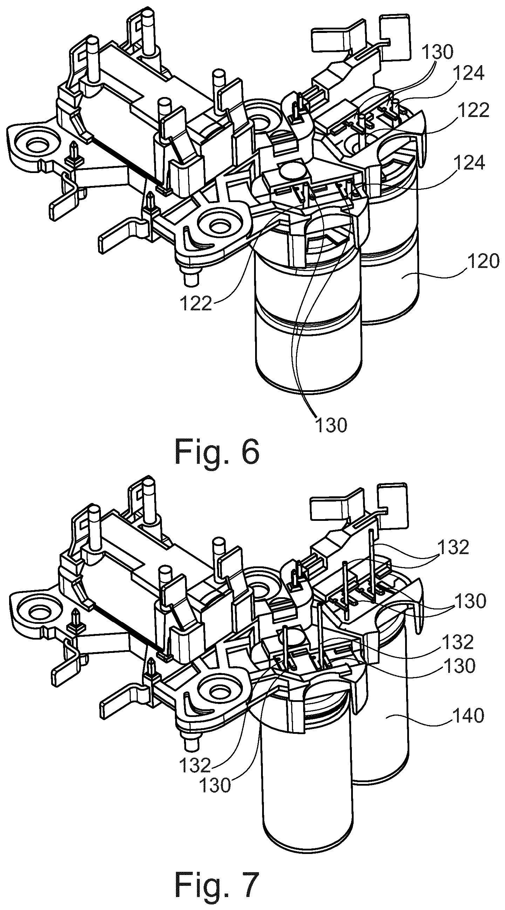

Par exemple, les éléments électriques peuvent être des composants de filtrage, tels que des condensateurs, comme représenté sur les figures 6 et 7.

Sur la figure 6, les bornes de connexion 130 des traces de puissance sont connectées électriquement à un élément électrique 120. L'élément électrique 120, ici un condensateur de liaison, peut comprendre une broche centrale 122 associée à une broche en périphérie 124.

Sur la figure 7, les bornes de connexion 130 des traces de puissance sont connectées électriquement à un élément électrique 140. L'élément électrique 140 comprend deux broches 132 disposées sensiblement symétriquement par rapport au centre de la base du composant électrique, les broches 132 et le centre de la base étant sensiblement alignés.

L'invention se rapporte également à un compresseur de suralimentation électrique, notamment pour véhicule automobile, comprenant un équipement électrique.

L'équipement électrique comprend une machine électrique et un convertisseur de tension. En particulier, le convertisseur de tension est monté sur la machine électrique.

Le convertisseur de tension est destiné à contrôler une énergie électrique échangée entre la machine électrique et une source d'alimentation électrique.

Le convertisseur de tension comprend le dispositif électrique tel que décrit précédemment, et un dissipateur thermique configuré pour refroidir le convertisseur de tension.

Une section d'un tel convertisseur de tension 200 est par exemple illustrée en figure 8.

Une paroi du dissipateur thermique 210 est disposée en vis-à-vis du dispositif électrique 100, notamment en vis-à-vis de la zone de réception 18 de la barre de connexion électrique 10, de sorte qu'au moins une partie du composant électrique 110 est reçue dans une cavité 220 de ladite paroi du dissipateur thermique 210.

Avantageusement, la hauteur de la paroi 24 de la zone de réception 18 supérieure ou égale à la moitié de la hauteur de l'inductance et inférieure à 75% de la hauteur de ladite inductance permet un refroidissement efficace de ladite inductance, tout en assurant son maintien mécanique.

En effet, une hauteur de paroi inférieure à 75% de la hauteur du composant électrique permet au composant électrique de venir au contact de la surface de refroidissement du dissipateur thermique, et une hauteur de paroi supérieure à 50% de la hauteur du composant électrique permet d'assurer le maintien mécanique dudit composant électrique.

La zone de réception 18 peut comprendre une ouverture configurée pour permettre la réception du composant électrique dans ladite zone de réception. Avantageusement, cette ouverture permet un refroidissement efficace du composant électrique.

Un matériau conducteur thermiquement peut remplir l'espace entre le composant électrique et la cavité 220 du dissipateur thermique 210. Le matériau conducteur thermiquement peut être un gel, une résine ou une colle.

Avantageusement, la cavité 220 du dissipateur thermique rempli de matériau conducteur thermiquement permet une dissipation thermique efficace de la chaleur générée par le composant électrique du dispositif électrique.

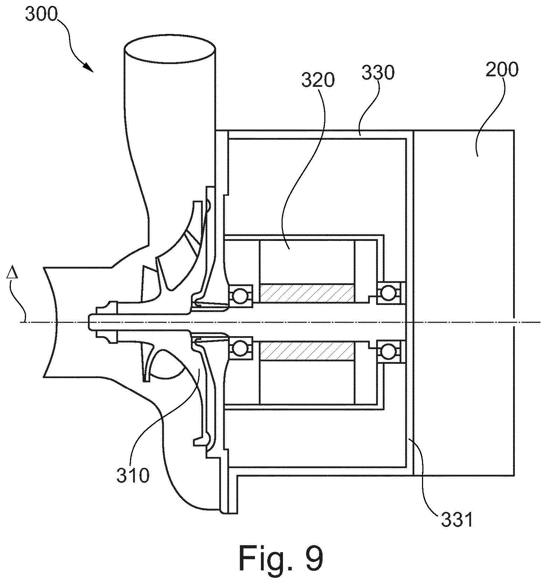

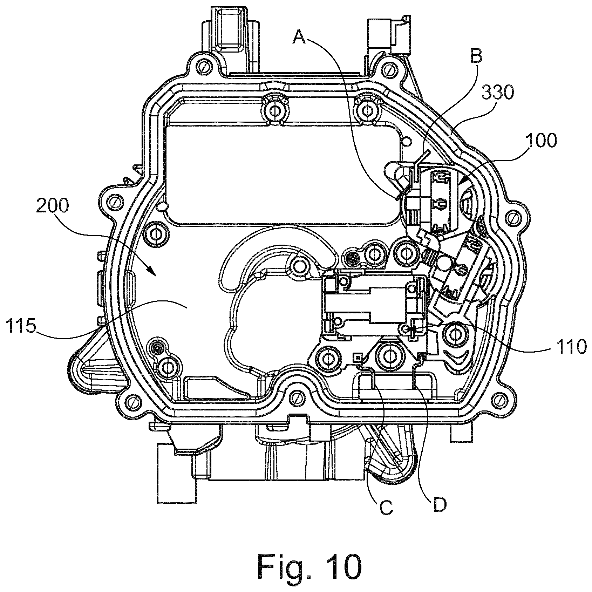

Les figures 9 et 10 illustrent un exemple de compresseur de suralimentation électrique 300 comprenant le convertisseur de tension 200 et la machine électrique 320, notamment une machine électrique tournante. Notamment, le compresseur de suralimentation électrique 300 est configuré pour être embarqué dans un véhicule pour comprimer les gaz d'admission du moteur à combustion du véhicule. En particulier, le réseau électrique est un réseau électrique du véhicule et comprend une batterie alimentant ledit réseau électrique. Le compresseur de suralimentation 300 comprend une roue de compression 310 destinée à comprimer l'air d'admission d'un moteur à combustion en association duquel le compresseur de suralimentation électrique 300 est monté. La roue de compression 310 est entrainée en rotation par la machine électrique 320. Notamment, le compresseur de suralimentation 300 peut comprendre un boitier 330 qui comporte la roue de compression 310, la machine électrique 320 et le convertisseur de tension 200. Ce boitier 330 peut être en plusieurs parties qui se montent les unes sur les autres pour former le boitier 330.

Dans le convertisseur de tension 200, le dispositif électrique 100 peut être monté sur une surface 115. Cette surface 115 est notamment perpendiculaire à l'axe de rotation Δ de la machine électrique 320. En particulier, la surface 115 de support peut être une face d'une paroi qui sépare deux logements du boitier 330. Par exemple, la surface 115 de support peut être une face d'une paroi 331 séparant un logement du boitier 330 comprenant le convertisseur de tension 200 d'un autre logement comprenant la machine électrique 320. Le dispositif électrique 100 est notamment connecté électriquement à des composants électroniques (non représentés) qui commandent l'énergie échangée avec la machine électrique 320, pour alimenter ces composants électroniques. Le dispositif électronique 100 peut être connecté à ces composants électroniques par l'intermédiaire de bornes A, B, notamment représentées sur les figures 3 et 10, situées en aval du composant électrique 110 décrit précédemment. La direction amont-aval correspondant à une direction depuis le réseau électrique vers la charge à laquelle est connecté le dispositif électrique 100. Le dispositif électrique 100 est notamment connecté au réseau électrique par des bornes C, D, notamment représentées sur les figures 3 et 8, situées en amont du composant électrique 110 décrit précédemment.

Dans l'exemple illustré en figures 9 et 10, la machine électrique 320 se trouve notamment entre le convertisseur de tension 200 et la roue de compression 310. Le convertisseur de tension 200 est ainsi placé à une extrémité axiale du compresseur de suralimentation électrique 300. Un capot peut venir fermer le convertisseur de tension 200 en venant en appui sur le boitier 330. La machine électrique 320 peut être positionnée le long de l'axe de rotation Δ entre le convertisseur de tension 200 et la roue de compression 310, c'est-à-dire entre une zone axiale correspondant au convertisseur de tension 200 et une zone axiale correspondant à la roue de compression 310. Cependant, l'agencement de la roue de compression 310, de la machine électrique 320 et du convertisseur de tension 200 peut être différent. Par exemple, le convertisseur de tension 200 peut être placé entre la machine électrique 320 et la roue de compression 310.

L'invention a également pour objet un procédé d'assemblage d'un dispositif électrique selon l'invention.

Le procédé d'assemblage comprend une étape de fourniture d'une barre de connexion électrique telle que décrite précédemment, et d'au moins un élément électrique.

La barre de connexion électrique fournie présente une zone de réception et une zone de connexion.

L'élément électrique est par exemple, une inductance dépourvue de boitier.

Le procédé d'assemblage comprend une étape d'insertion du composant électrique dans la zone de réception. Plus précisément, les bornes de connexion du composant électrique sont insérées dans les orifices traversants du surmoulage correspondants. Les bornes de connexion du composant électrique peuvent être insérées en force dans les orifices traversants.

Le procédé d'assemblage comprend une étape de connexion, au cours de laquelle les bornes de connexion du composant électrique sont connectées électriquement aux traces de puissance. L'étape de connexion peut être réalisée par soudure.

## Revendications

1. Barre de connexion électrique (10) destinée à échanger de l'énergie électrique entre un équipement électrique embarqué dans un véhicule automobile, et un réseau électrique du véhicule automobile, la barre de connexion électrique (10) comprenant :
- au moins une trace de puissance (12, 13, 14, 15) destinée à transmettre un courant entre le réseau électrique du véhicule automobile et l'équipement électrique embarqué dans le véhicule automobile, la au moins une trace de puissance (12, 13, 14, 15) étant en partie surmoulée de matériau isolant électriquement,
- une zone de réception (18) conformée pour recevoir un composant de filtrage (110),
- une zone de connexion (20), dans laquelle la au moins une trace de puissance (12, 13, 14, 15) est destinée à être connectée électriquement au composant de filtrage (110) de sorte à filtrer l'énergie électrique destinée à alimenter les modules électroniques de puissance, et
dans laquelle la zone de réception (18) et la zone de connexion (20) sont séparées par le surmoulage (16),
et dans laquelle la zone de réception (18) est formée dans le surmoulage (16) de la au moins une trace de puissance (12, 13, 14, 15).
et dans laquelle le surmoulage (16) des traces de puissance (12, 14) comprend une face supérieure comprenant la zone de connexion (20), et une face inférieure comprenant la zone de réception (18).

2. Barre de connexion électrique selon la revendication 1, dans laquelle le composant de filtrage est une inductance.

3. Barre de connexion électrique selon l'une des revendications 1 ou 2, dans laquelle la zone de réception (18) est conformée pour recevoir en force le composant de filtrage (110).

4. Barre de connexion électrique selon l'une des revendications précédentes, dans laquelle la zone de réception (18) comprend au moins une paroi (22) formant le fond de ladite zone de réception (18) et une paroi (24) s'étendant depuis ledit fond dans une direction sensiblement transversale, notamment dans une direction sensiblement perpendiculaire, par rapport audit fond.

5. Dispositif électrique (100) comprenant :
- une barre de connexion électrique (10) selon l'une des revendications 1 à 4, et
- un composant de filtrage (110),
dans lequel le composant de filtrage (110) est reçu dans la zone de réception (18) de la barre de connexion électrique (10), et
dans lequel une borne (112) du composant de filtrage (110) est connectée électriquement à la au moins une trace de puissance (12, 13, 14, 15) dans la zone de connexion (20) de la barre de connexion électrique (10).

6. Dispositif électrique selon la revendication 5, dans lequel la borne (112) du composant de filtrage (110) est soudée dans la zone de connexion (20) de la barre de connexion électrique (10).

7. Dispositif électrique selon l'une des revendications 5 ou 6, dans lequel le surmoulage (16) comprend un orifice traversant (114) recevant la borne (112) du composant de filtrage (110).

8. Dispositif électrique selon l'une des revendications 5 à 7, dans lequel le composant de filtrage est une inductance.

9. Convertisseur de tension (200) destiné à contrôler une énergie électrique échangée entre une machine électrique (320) et une source d'alimentation électrique, comprenant :
- un dispositif électrique (100) selon l'une des revendications 5 à 8, et
- un dissipateur thermique (210) configuré pour refroidir le convertisseur de tension (200),
dans lequel une paroi du dissipateur thermique (210) est disposée en vis-à-vis du dispositif électrique (100), de sorte que au moins une partie du composant de filtrage (110) est reçue dans une cavité (220) de ladite paroi du dissipateur thermique (210).

10. Equipement électrique comprenant une machine électrique (320) et un convertisseur de tension (200) selon la revendication 9, dans lequel le convertisseur de tension (200) est monté sur la machine électrique (320).

11. Compresseur de suralimentation électrique, pour véhicule automobile, comprenant un équipement électrique selon la revendication 10.

## Patentansprüche

1. Elektrische Anschlussschiene (10), die dazu bestimmt ist, elektrische Energie zwischen einer in ein Kraftfahrzeug eingebauten elektrischen Einrichtung und einem Stromnetz des Kraftfahrzeugs auszutauschen, die elektrische Anschlussschiene (10) umfassend:
- mindestens eine Leistungsbahn (12, 13, 14, 15), die dazu bestimmt ist, einen Strom zwischen dem Stromnetz des Kraftfahrzeugs und der in das Kraftfahrzeug eingebauten elektrischen Einrichtung zu übertragen, wobei die mindestens eine Leistungsbahn (12, 13, 14, 15) teilweise mit elektrisch isolierendem Material umspritzt ist,
- einen Aufnahmebereich (18), der dazu ausgebildet ist, ein Filterbauteil (110) aufzunehmen,
- einen Anschlussbereich (20), wobei die mindestens eine Leistungsbahn (12, 13, 14, 15) dazu bestimmt ist, elektrisch an das Filterbauteil (110) angeschlossen zu werden, so dass die elektrische Energie, die dazu bestimmt ist, die elektronischen Leistungsmodule zu versorgen, gefiltert wird, und
wobei der Aufnahmebereich (18) und der Anschlussbereich (20) durch die Umspritzung (16) getrennt sind,
und wobei der Aufnahmebereich (18) in der Umspritzung (16) der mindestens einen Leistungsbahn (12, 13, 14, 15) gebildet ist,
und wobei die Umspritzung (16) der Leistungsbahnen (12, 14) eine den Anschlussbereich (20) umfassende Oberseite und eine den Aufnahmebereich (18) umfassende Unterseite umfasst.

2. Elektrische Anschlussschiene nach Anspruch 1, wobei das Filterbauteil eine Induktivität ist.

3. Elektrische Anschlussschiene nach einem der Ansprüche 1 oder 2, wobei der Aufnahmebereich (18) dazu ausgebildet ist, das Filterbauteil (110) unter Krafteinwirkung aufzunehmen.

4. Elektrische Anschlussschiene nach einem der vorhergehenden Ansprüche, wobei der Aufnahmebereich (18) mindestens eine Wand (22) umfasst, die den Boden des Aufnahmebereichs (18) bildet, und eine Wand (24), die sich von dem Boden in eine im Wesentlichen quer verlaufende Richtung erstreckt, insbesondere in eine im Wesentlichen senkrecht zu dem Boden verlaufende Richtung.

5. Elektrische Vorrichtung (100), umfassend:
- eine elektrische Anschlussschiene (10) nach einem der Ansprüche 1 bis 4, und
- ein Filterbauteil (110),
wobei das Filterbauteil (110) in dem Aufnahmebereich (18) der elektrischen Anschlussschiene (10) aufgenommen ist, und
wobei eine Klemme (112) des Filterbauteils (110) elektrisch an die mindestens eine Leistungsbahn (12, 13, 14, 15) in dem Anschlussbereich (20) der elektrischen Anschlussschiene (10) angeschlossen ist.

6. Elektrische Vorrichtung nach Anspruch 5, wobei die Klemme (112) des Filterbauteils (110) in den Anschlussbereich (20) der elektrischen Anschlussschiene (10) angeschweißt ist.

7. Elektrische Vorrichtung nach einem der Ansprüche 5 oder 6, wobei die Umspritzung (16) eine durchgehende Öffnung (114) umfasst, welche die Klemme (112) des Filterbauteils (110) aufnimmt.

8. Elektrische Vorrichtung nach einem der Ansprüche 5 bis 7, wobei das Filterbauteil eine Induktivität ist.

9. Spannungswandler (200), der dazu bestimmt ist, eine zwischen einer elektrischen Maschine (320) und einer Stromversorgungsquelle ausgetauschte elektrische Energie zu steuern, umfassend:
- eine elektrische Vorrichtung (100) nach einem der Ansprüche 5 bis 8, und
- einen Kühlkörper (210), der dazu ausgestaltet ist, den Spannungswandler (200) zu kühlen,
wobei eine Wand des Kühlkörpers (210) gegenüber der elektrischen Vorrichtung (100) angeordnet ist, so dass mindestens ein Teil des Filterbauteils (110) in einem Hohlraum (220) der Wand des Kühlkörpers (210) aufgenommen ist.

10. Elektrische Einrichtung, umfassend eine elektrische Maschine (320) und einen Spannungswandler (200) nach Anspruch 9, wobei der Spannungswandler (200) an der elektrischen Maschine (320) angebracht ist.

11. Elektrischer Turbolader für ein Kraftfahrzeug, umfassend eine elektrische Einrichtung nach Anspruch 10.

## Claims

1. Electrical connection bar (10) intended to exchange electrical energy between electrical equipment on board a motor vehicle and an electrical network of the motor vehicle, the electrical connection bar (10) comprising:
- at least one power trace (12, 13, 14, 15) intended to transmit a current between the electrical network of the motor vehicle and the electrical equipment on board the motor vehicle, the at least one power trace (12, 13, 14, 15) being partly overmoulded with electrically insulating material,
- a reception area (18) designed to receive a filtering component (110),
- a connection area (20) in which the at least one power trace (12, 13, 14, 15) is intended to be electrically connected to the filtering component (110) so as to filter the electrical energy intended to power the power electronic modules, and
wherein the reception area (18) and the connection area (20) are separated by the overmoulding (16),
and wherein the reception area (18) is formed in the overmoulding (16) of the at least one power trace (12, 13, 14, 15),
and wherein the overmoulding (16) of the power traces (12, 14) comprises an upper face comprising the connection area (20), and a lower face comprising the reception area (18).

2. Electrical connection bar according to Claim 1, wherein the filtering component is an inductor.

3. Electrical connection bar according to either of Claims 1 and 2, wherein the reception area (18) is designed to receive the filtering component (110) in a force-fitting manner.

4. Electrical connection bar according to one of the preceding claims, wherein the reception area (18) comprises at least one wall (22) forming the bottom of said reception area (18) and a wall (24) extending from said bottom in a substantially transverse direction, in particular in a substantially perpendicular direction, in relation to said bottom.

5. Electrical device (100) comprising:
- an electrical connection bar (10) according to one of Claims 1 to 4, and
- a filtering component (110),
wherein the filtering component (110) is received in the reception area (18) of the electrical connection bar (10), and
wherein a terminal (112) of the filtering component (110) is electrically connected to the at least one power trace (12, 13, 14, 15) in the connection area (20) of the electrical connection bar (10).

6. Electrical device according to Claim 5, wherein the terminal (112) of the filtering component (110) is soldered into the connection area (20) of the electrical connection bar (10).

7. Electrical device according to either of Claims 5 and 6, wherein the overmoulding (16) comprises a through-hole (114) receiving the terminal (112) of the filtering component (110).

8. Electrical device according to one of Claims 5 to 7, wherein the filtering component is an inductor.

9. Voltage converter (200) intended to control electrical energy exchanged between an electrical machine (320) and an electrical power source, comprising:
- an electrical device (100) according to one of Claims 5 to 8, and
- a heat sink (210) configured to cool the voltage converter (200),
wherein a wall of the heat sink (210) is arranged opposite the electrical device (100) such that at least a portion of the filtering component (110) is received in a cavity (220) in said wall of the heat sink (210).

10. Electrical equipment comprising an electrical machine (320) and a voltage converter (200) according to Claim 9, wherein the voltage converter (200) is mounted on the electrical machine (320).

11. Electrical supercharger for a motor vehicle, comprising electrical equipment according to Claim 10.
